(19) Europäisches Patentamt

European Patent Office

Office européen des brevets

(11) **EP 0 365 312 B1**

(12) **EUROPEAN PATENT SPECIFICATION**

(45) Date of publication and mention
of the grant of the patent:
**27.12.1996  Bulletin 1996/52**

(51) Int Cl.⁶: **H01L 31/18**, H01L 31/0352,
H01L 27/144, H01L 27/146

(21) Application number: **89310726.8**

(22) Date of filing: **18.10.1989**

(54) **Semiconductor device and signal processing device having said device provided therein**

Halbleiteranordnung und eine Signalbehandlungsvorrichtung mit dieser Anordnung

Dispositif semi-conducteur et dispositif de traitement de signaux comportant ce dispositif

(84) Designated Contracting States:
**DE FR GB NL**

(30) Priority: **20.10.1988  JP  262929/88**
**13.10.1989  JP  265117/89**

(43) Date of publication of application:
**25.04.1990  Bulletin 1990/17**

(73) Proprietor: **CANON KABUSHIKI KAISHA**
**Tokyo (JP)**

(72) Inventors:
• **Yamada, Katsuhiko**
  **Atsugi-shi Kanagawa-ken (JP)**
• **Sugawa, Shigetoshi**
  **Atsugi-shi Kanagawa-ken (JP)**
• **Mizutani, Hidemasa**
  **Sagamihara-shi Kanagawa-ken (JP)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
**EP-A- 0 128 828**          **EP-A- 0 216 426**
**EP-A- 0 323 183**          **FR-A- 2 126 277**
**FR-A- 2 215 702**          **US-A- 4 209 806**
**US-A- 4 236 831**

## Description

This invention relates to a semiconductor device having a plurality of charge accumulation type sensor elements.

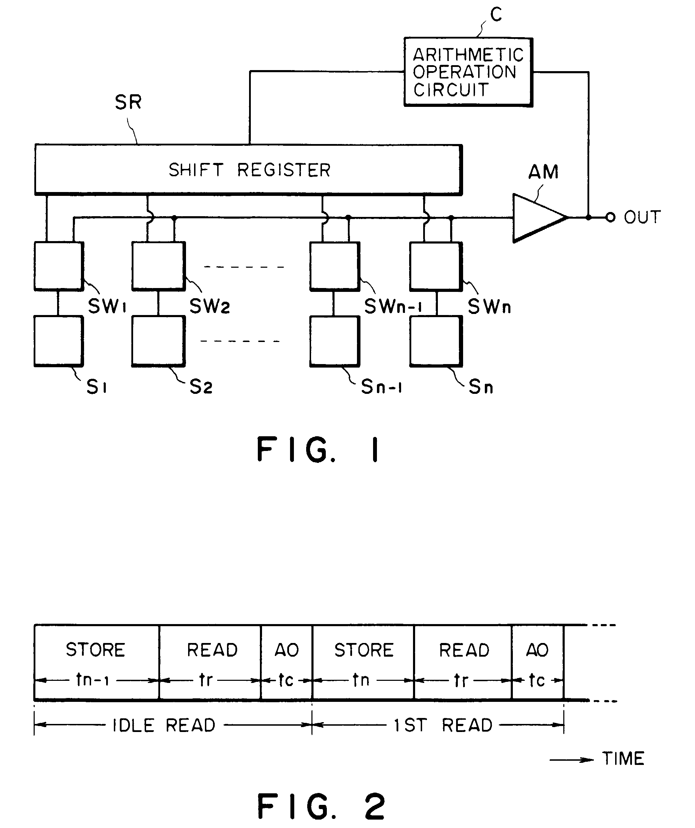

A sensor device of the charge accumulation type is known, having a constitution as shown in Figure 1. A number (n) of sensor cells S1 - Sn are connected electrically to respective switching circuits SW1 - SWn for reading the signals from said sensor cells. The switching circuits SW1 - SWn are electrically connected to a shift register SR, successively scanned by said shift register SR and the signals accumulated in the respective sensor cells are successively delivered to an amplifier AM and outputted from an output terminal OUT. The output from the amplifier AM is subjected to peak detection and average value arithmetic operation in the arithmetic operation circuit C to determine the accumulation time in the sensor cell for the next time and feedbacked so as to deliver a control signal to the shift register SR. The reason why the accumulation time is determined on the basis of the signal read from the sensor cell is because the accumulation time influences greatly sensitivity and S/N ratio.

Fig. 2 is a schematic diagram for illustration of the signal read cycle of the photosensor of the above charge accumulation type.

As shown in the same Figure, the signal read cycle for one time requires, in addition to the accumulation time ($t_n$) and the read time ($t_r$), the arithmetic operation time ($t_c$) for calculating the accumulation time for the next time ($t_{n+1}$), and further required the idle time of one cycle which is not finally outputted for calculating the accumulation time of the first time ($t_{n-1} + t_r + t_c$).

However, the arithmetic operation time ($t_c$), the idle time as mentioned above have become obstacles in high speed actuation, and also made the arithmetic operation circuit of signals complicated, and therefore they have been the task to be solved in making the signal processing device lower in cost and a unit of higher reliability.

EP-A-0216426 discloses an imaging device including a series of infra-red detector elements. Each detector element is coupled to an individual capacitor. Voltage reading means are coupled between the capacitor and a signal output to produce an output signal indicative of the amount of current integrated at the capacitors.

FR-A-2 126 277 discloses a semiconductor device including an array of charge storage capacitors, wherein charge from the storage capacitors are read out by means of switching transistors.

According to a first aspect of the invention, there is provided a semiconductor device, comprising a plurality of charge accumulation type sensor elements each of said sensor elements having a semiconductor active region; and a plurality of respective charge transferring elements for transferring charge signals stored in said sensor elements, each of said charge transferring elements corresponding to a respective one of said sensor elements; characterised by a common conductive member provided with an insulating member for capacitively coupling said common conductive member to the output of each of said sensor elements through the insulating member thereby to develop a voltage signal on said common conductive member corresponding to the average of the output voltages of the plurality of charge accumulation sensor elements; and operating means for detecting the voltage signal on said common conductive member and for producing a drive signal to drive said charge transferring elements in response to the voltage on said common conductive member.

The semiconductor device may be used in a signal processing apparatus.

According to a second aspect of the invention, there is provided a signal processing apparatus, comprising a semiconductor device according to the first aspect of the invention and further comprising signal readout means comprising driving means for driving said charge transferring elements in accordance with the voltage signal on said common conductive member.

The semiconductor device according to the first aspect of the invention may also be included in a scanner device for reading an image, a fascimile device and a camera.

The invention will now be described by way of example only, with reference to the accompanying drawings in which:

Fig. 1 is a schematic block diagram for illustration of the reading method of the photoelectric converting device of the prior art;
Fig. 2 is a schematic diagram for illustration of the reading method and the time required for reading of the photoelectric converting device of the prior art;
Fig. 3 is a schematic diagram showing an example of the area sensor according to the present invention;
Fig. 4A to 4D are schematic sectional views for illustration of the method for producing the photosensor cell according to the present invention;
Fig. 5 is a schematic top view showing an example of the photosensor cell according to the present invention;
Fig. 6 is a schematic sectional view taken along the line A-A' in Fig. 5;
Fig. 7 is a schematic sectional view taken along the line B-B' in Fig. 5;
Fig. 8 is the equivalent circuit diagram of the photosensor cell according to the present invention;
Fig. 9 is a schematic sectional view showing the line sensor according to the present invention;
Fig. 10 is the equivalent circuit diagram of the line sensor shown in Fig. 9;

Fig. 11 is a schematic diagram for illustration of the charge accumulation type photosensor;

Fig. 12 is a schematic diagram for illustration of the reading method and the time required for reading of the charge accumulation type photosensor according to the present invention;

Fig. 13 is a circuit constitutional diagram of the photosensor device according to the second example of the present invention;

Fig. 14A is a schematic top view of the photosensor device shown in Fig. 13;

Fig. 14B is a schematic sectional view taken along the line D-D' in Fig. 14A;

Fig. 14C is a schematic sectional view taken along the line E-E' in Fig. 14A; and

Fig. 15 is a schematic diagram showing an example of the signal processing device according to the present invention.

DESCRIPTION OF THE PREFERRED EMBODIMENTS

Referring now to the drawings, the embodiments of the present invention are described.

The present invention is a semiconductor device as described above, comprising a constitution having an electroconductive layer provided through an insulating layer provided on a plurality of charge accumulating sections, the respective charge accumulating sections and the electroconductive layer being capacitively coupled commonly.

When the semiconductor device is made a charge accumulation type sensor section, if the signals accumulated begin to be read from the respective accumulation type sensor elements, the voltage accumulate $(V_j)$ is transmitted through capacitance $(C_X)$ to the electroconductive layer. If the floating capacitance of the electroconductive layer and the earthed potential is made $(C_Y)$, the voltage of the electroconductive layer $(V_X)$ becomes:

$$V_X = \sum_{j=1\sim n} V_j \frac{C_X}{n C_X + C_Y}$$

$(V_1 - V_n$: sensor output voltages).

Here, since the relationship of $CX \gg CY$ is generally valid, the above formula becomes:

$$V_X = \frac{\sum_{j=1\sim n} V_j}{n}$$

and this indicates that the voltage $V_X$ becomes the average value of the voltages accumulated of the respective sensors.

More specifically, in the semiconductor device, since the voltage $V_X$ of the above electroconductive layer is outputted always during accumulation actuation of charges in the charge accumulation type sensor element, it becomes possible to perform arithmetic operation of the optimum accumulation time during the accumulation actuation.

The constitution for accomplishing the objects of the present invention is a semiconductor device having a plurality of charge accumulation type sensor elements and a common electroconductive member capacitively coupled commonly through an insulating member to each of said plurality of sensor elements, wherein said semiconductor device outputs a signal voltage corresponding to the average value of the respective voltages accumulated in said plurality of sensor elements, or a signal processing device comprising:

a semiconductor device as described above having a plurality of charge accumulation type sensor elements and a common electroconductive member capacitively coupled commonly through an insulating member to each of said plurality of sensor elements;
a driving means for reading the signal from said sensor element;
a reading means for reading the output signal from said electroconductive members,
said reading means feedbacking the output signal outputted from said electroconductive members to said driving means.

These semiconductor device, driving means, reading means, etc. may have, for example, (A) a constitution in which they are integrally prepared on a single crystalline substate, or (B) the respective means may be formed on separate substrates, arranged on one support and electrically connected to each other. Alternatively, (C) these may be provided respectively on separate supports and connected to each other.

These constitutions may be suitably selected, and for example, when the semiconductor device has a single crystal semiconductor substrate, the above structure (A) is preferable for miniaturization, and in the case of one having a photoelectric converting section on an insulating substrate such as an equal size type lengthy sensor, the above structure (B) is preferable.

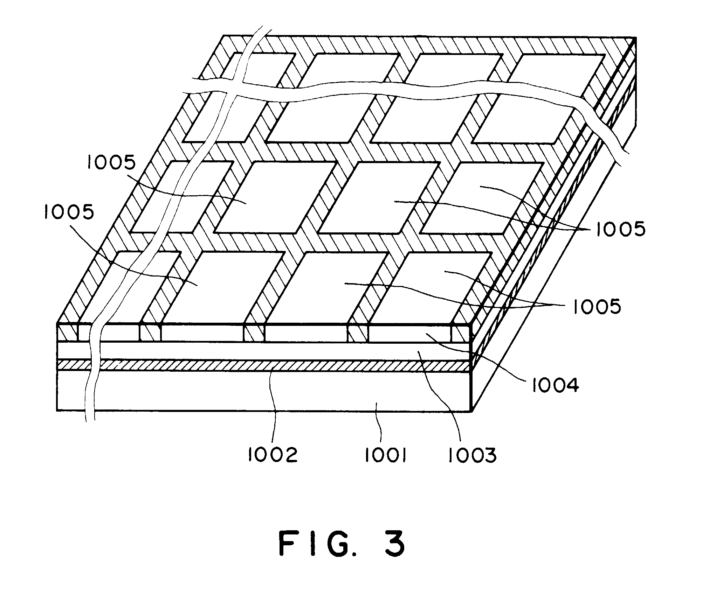

As preferred embodiments of the present invention, there may be included line sensor, area sensor, etc. Fig. 3 shows a schematic perspective view showing the above photosensor device. 1001 denotes a substrate having at least an insulating surface, which may be an insulating substrate itself such as glass, alumina, sapphire, and other various ceramics, or one having an insulating layer such as SixOy or SixNy formed on a semiconductor substrate such as silicon single crystal, etc. Further, there may be employed a substrate made of metal having an insulating layer on the surface, for example, a metal plate of Al having an insulating layer such as $Al_2O_3$, etc. formed thereon.

1002 denotes an electroconductive layer, comprising a metal material such as Al, Cr, Ni, Cu, Au, Ag, Pt, W, etc. or an oxide such as $SnO_2$, ITO, etc. formed by vapor deposition or the sputtering method.

1003 denotes an insulating layer, comprising silicon oxide (SixOy), silicon nitride (SixNy), silicon oxide nitride (SixOyNz) formed by the sputtering method or the CVD method. Of course, PSG film, BSG film or BPSG film doped with P (phosphorus) or B (boron) may be used.

1004 denotes a semiconductor layer constituting an active region.

In the semiconductor layer 1004, photosensitive photoelectric converting sections or switch element, etc. are formed as the charge accumulation type sensor element. Accordingly, as the semiconductor layer, for example, it may be selected from such materials as Si, Ge, Se, SiGe, SiC, GaAs, etc., and its structural state is not limited to single crystal, but may be suitably selected from polycrystalline, amorphous (including microcrystalline structure) structures. Also, its layer constitution is not limited to a single layer, but a multi-layer constitution or a super-lattice constitution may be employed.

As a particularly preferable constitution, there may be employed single crystalline silicon or non-single crystalline silicon such as polycrystalline, amorphous silicon, etc., amorphous silicon carbide (hereinafter called a-SiC), amorphous selenium (a-Se) or a super-lattice structure of a-Si and a-Si$_x$Ny.

The sensor cell 1005 thus formed is arranged in a plural number two-dimensionally in X-Y matrix to form an area sensor device.

Also, for formation of the semiconductor layer 1004 as described above, all film formation methods can be used. Particularly, when a single crystalline material is used for making a semiconductor device with high mobility of carriers, it is preferable to use a single crystal formed according to the crystal formation method proposed by the present Applicant (Assignee) (see published European Patent Application No. 0.244.081). Of course, it is possible to use one formed into a single crystal by recrystallization by the laser annealing method, etc. well known in the art.

The reason why particularly the former is preferable is that a single crystal can be directly formed according to the gas phase growth method such as the CVD method, etc. More specifically, as the surface on which a single crystal is to be formed, a nucleation surface and a non-nucleation surface with different nucleation densities are formed. At this time, the nucleation surface made fine so as to form only a nucleus to be grown into a single crystal. When gas phase growth is permitted to proceed on such surface by setting suitably conditions of desired gas species, pressure, temperature, a single crystal based on said nucleation surface can be obtained.

As a representative material constituting the non-nucleation surface, $SiO_2$ may be employed, and as the material constituting the nucleation surface, $Si_3N_4$, etc. may be employed.

As the structure of the photoelectric converting section, a photovoltaic type or a photoconductive type having a charge accumulation section may be employed. Of course, a photovoltaic type having added a charge accumulation section may be also employed.

[First example]

The example shown below is one in which the present invention is used for the line type photosensor.

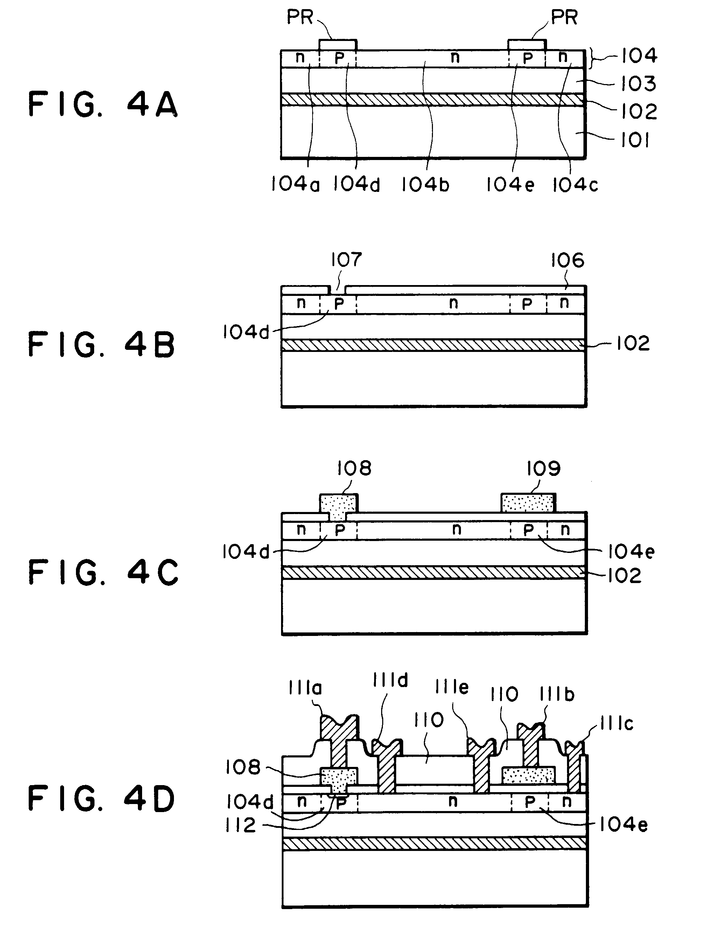

Figs. 4A- 4D are schematic sectional views showing the preparation steps of the line type photosensor using the present invention.

First, as shown in Fig. 4A, on a $SiO_2$ substrate 101 was deposited an Al layer 102 as the common electroconductive layer to a thickness of 1 μm by the sputtering method.

Further, on the Al layer 102 was formed a $Si_3N_4$ layer 103 as the silicon nitride film according to the low pressure CVD method (LPCVD) to form an insulating layer with a thickness of 1 μm.

On the $Si_3N_4$ layer 103 is formed a poly-Si with large particle sizes of 1.0 μm or more as the semiconductor layer 104, and the poly-Si with large particle sizes of 1.0 μm or more should be preferably prepared by use of the formation method of a polycrystalline film proposed by the present Applicant in Japanese Patent Applications Nos. 62-73629 and 62-73630. Accordingly, as the deposition conditions of the semiconductor layer 104, by use of $SiH_2Cl_2$ as the source gas, $H_2$ as the carrier gas, HCl as the etching gas and B2H6 as the doping gas, $p^+$ type semiconductor layer was formed as the semiconductor layer 104 according to the above-mentioned method.

Further, on a desired region on the semiconductor 104 was formed a photoresist PR, which was subjected to patterning, and P was diffused according to the thermal diffusion method into the region not covered with the photoresist to form n-type semiconductor regions 104a, 104b, 104c. In this way, the semiconductor regions 104a, and 104b which should constitute the photosensor element and the semiconductor regions 104b, 104e and 104c which should constitute the signal processing circuit section could be formed in the lateral direction.

Next, as shown in Fig. 4B, an insulating film 106 comprising $SiO_2$ was formed by use of the CVD method, and a contact hole 107 was formed at a desired position on the above p-type semiconductor region 104d.

Next, as shown in Fig. 4C, low resistance polycrystalline silicons 108, 109 doped at high concentrations with the p-type impurity were formed according to the CVD method on the p-type semiconductor regions 104d, 104e. The polycrystalline silicon on the semiconductor region 104e becomes the gate electrode for the MOS transistor which forms the processing circuit.

Next, as shown in Fig. 4D, a $SiO_2$ layer 110 as the interlayer insulating layer was deposited according to the CVD method on the whole surface, a contact hole was formed on a desired region and Al was deposited by the sputtering method, followed by etching to form Al electrodes 111a - 111e. By the heat treatment during this process, the p-type impurity was diffused into the semiconductor region 104d from the above polycrystalline silicon 108 to form a very thin semiconductor layer 112, whereby ohmic contact between the polycrystalline silicon 108 and the semiconductor region 104d was rendered possible.

In the following, the line type photosensor device with the above constitution is described in more detail.

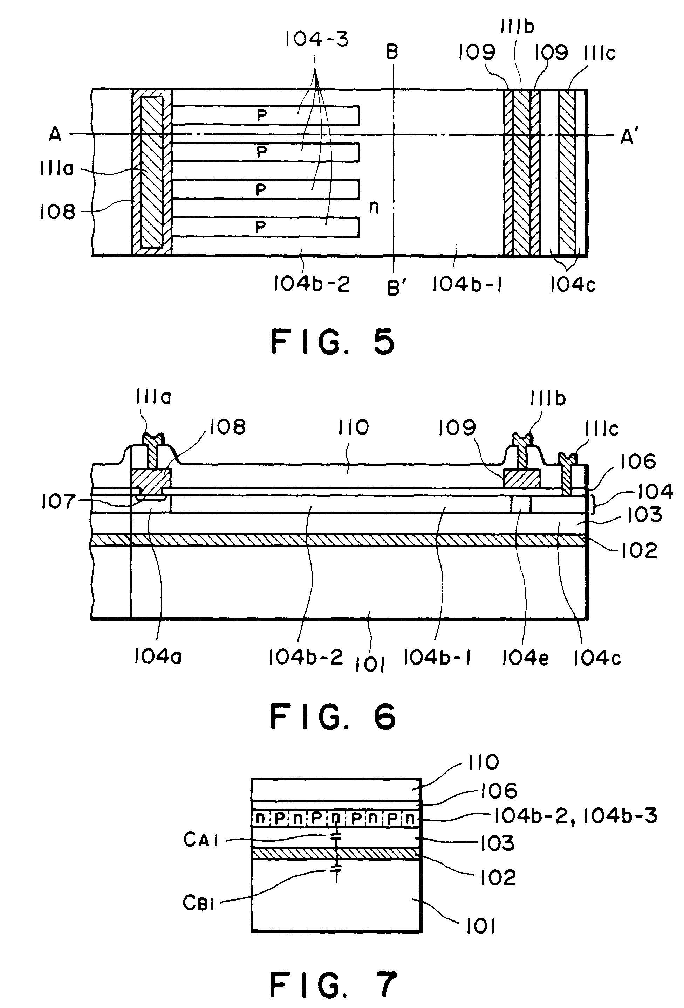

Fig. 5 is a schematic plan view of one cell of the photosensor device by use of the present invention.

Fig. 6 is a schematic longitudinal sectional view along the line A-A' of one cell of the photosensor device shown in Fig. 5, and Fig. 7 is a schematic sectional view along the line B-B' for illustration of the constitution according to the present invention of the photosensor device shown in Fig. 5.

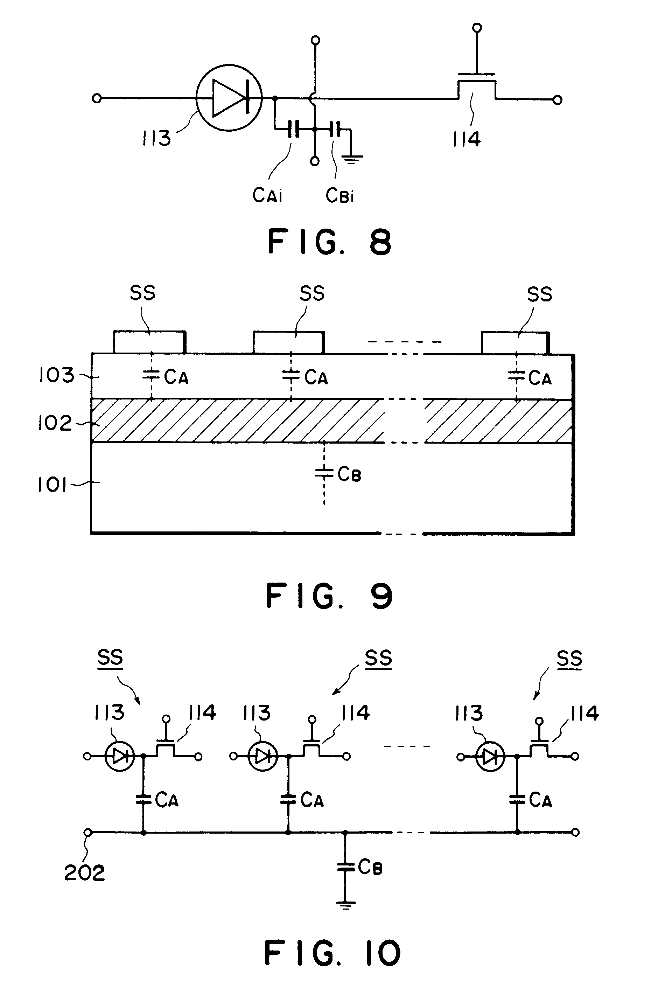

Fig. 8 is an equivalent circuit of one cell of the above photosensor.

As shown in Figs. 5, 6 and 7, on an insulating layer 103 provided through an intermediary electroconductive layer 102 on a substrate 101 is formed a sensor cell having a light-receiving section and a switching element section.

As the light-receiving section, it takes a constitution having a photodiode including a PN junction portion between 104a and 104b-3 which are the p-type semiconductor regions and the 104b-2 which is the n-type semiconductor region.

As the switching element section, it takes a constitution including a MOS transistor having a source region 104b-1 which is the n-type semiconductor region, a channel region 104e comprising the p-type semiconductor and a drain region 104c comprising the n-type semiconductor.

The PN junction of the photodiode, as shown in Fig. 5, has a "comb" shape formed by arrangement of a plurality of strips of the p-type semiconductor regions 104b-3 as the anode region, whereby the carriers formed by light can be easily integrated.

Also, the n-type semiconductor region 104b-2 as the cathode region and the n-type semiconductor region 104b-1 as the source region of the MOS transistor are the common semiconductor layer region.

111a is an anode electrode wiring which is electrically connected through an anode electrode 108 comprising a polysilicon to the anode region 104d of the semiconductor layer 104, 111b is a gate electrode wiring which is electrically connected to the gate electode 109 of the MOS transistor comprising a polysilicon, and 111c is a drain electrode wiring which is electrically connected to the drain region 104c.

The light incident on the unit element with such a constitution will generate carriers, and the carriers generated are accumulated by PN junction as electrons and positive holes. The carriers (electrons) accumulated apply signals on the gate electrode to change the potential of the channel region 104e and move electrons from the source region to the drain region, and read as the electrical signals.

In the sensor device of this Example, as shown in Fig. 7, The semiconductor layer 104 and the Al layer 102 form a parasitic capacitance $C_{Ai}$ with the $Si_3N_4$ layer 103 sandwiched therebetween, and further a floating capacitance $C_{Bi}$ is formed between the Al layer 102 and the earth.

This is represented equivalently by the equivalent circuit diagram as shown in Fig. 8.

In Fig. 8, 113 denotes a diode as the photosensor, the cathode side of which diode 113 is connected to the MOS transistor 114, and also earthed through the parasitic capacitance $C_{Ai}$ and the floating capacitance $C_{Bi}$.

The photosensor device is constituted by juxtaposing plurality of the cell portions as shown in Fig. 5 in an array with intervals.

Fig. 9 is a schematic illustration showing the photosensor device having plurality of the above-described photosensors arranged with intervals.

Fig. 10 is an equivalent circuit diagram of the photosensor device shown in Fig. 9.

As can be understood from these Figures, parasitic capacitance $C_A$ is formed respectively by sandwiching the insulating layer 103 with the respective sensor cells SS and the Al layer 102 as the common electroconductive layer. Also, between the Al layer 102 and the earth, a floating capacitance $C_B$ is formed.

More specifically, to explain by referring to Fig. 10, the cathode side of the photodiode 113 of each photosensor cell is connected to the MOS transistor 114, and also connected through the parasitic capacitance $C_A$ to the Al layer 102, with the Al layer 102 being commonly earthed through the floating capacitance $C_B$.

When each photodiode 113 begins to read, the accumulated voltage Vi is transmitted through the capacitance $C_A$ without breaking to the Al layer 102. At this time, the voltage $V_A$ of the Al layer 102 which is the electroconductive layer becomes:

$$V_A = \sum_{i=1\sim n} V_i \frac{C_A}{n C_A + C_B}$$

($V_1$ - $V_n$: photodiode output voltages)

Here, in the structure of this Example, since the relationship of $C_A \gg C_B$ is valid, the above formula becomes:

$$V_A = \frac{\sum_{i=1\sim n} V_i}{n}$$

which shows that the $V_A$ becomes the average value in each photodiode.

Also, since the above output voltage is outputted always during accumulation actuation, it becomes possible to perform arithmetic operation of the optimum store time during accumulation operation.

Therefore, since the photosensor device of this Example can perform arithmetic operation following simultaneously the optimum store time even if the accumulation ability of the photosensor may be varied, it has the specific feature that stable signals can be obtained at real time.

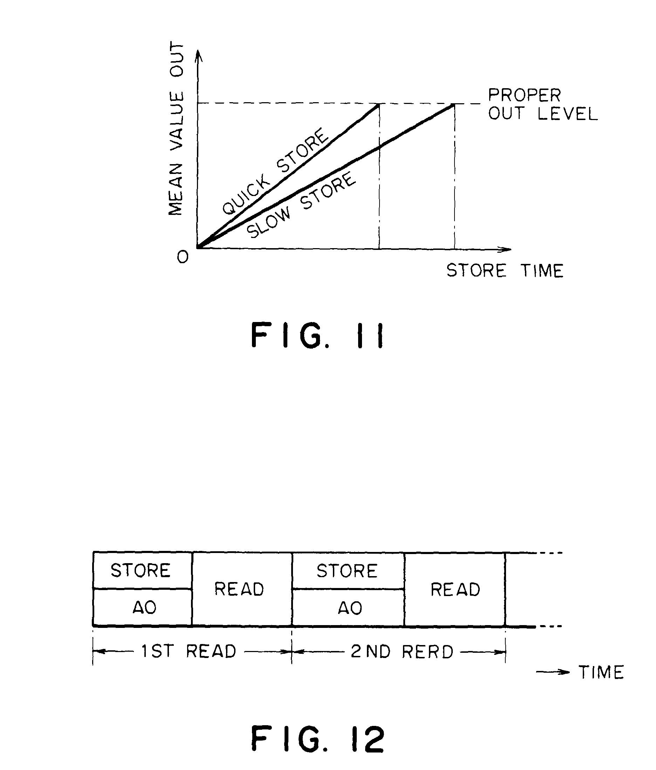

As described above, the photosensor device of this Example performs arithmetic operation of the accumulation time during accumulation actuation as shown in Fig. 12, whereby no idle read becomes necessary and the read speed can be made higher. Also, no circuit for arithmetic operation of average value is required to make the unit constitution simpler and also lower the cost.

Thus, as described in detail in the above, according to the semiconductor device of this Example, the average value of the outputs from the charge accumulation type sensor section can be outputted without breaking and at all times. As the result, a semiconductor photosensor device capable of high speed output can be provided with a simple constitution. [Second example]

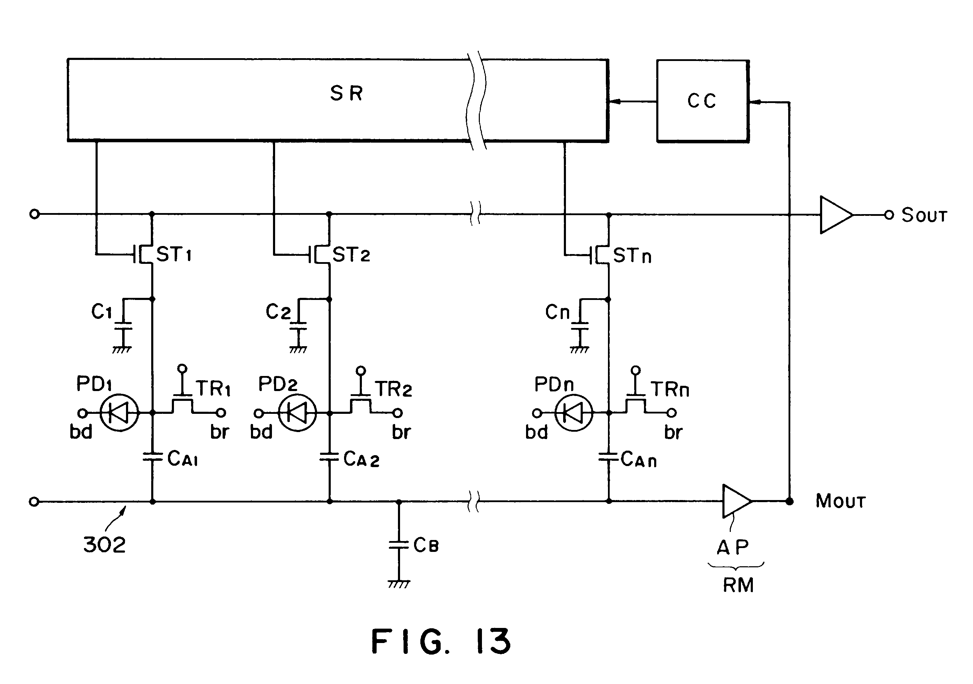

Fig. 13 is a circuit constitutional diagram showing the photosensor device according to the second example. $PD_1$ - $PD_n$ are photodiodes as the light-receiving element, $C_1$ - $C_n$ are capacitors provided corresponding to the photodiodes $PD_1$ - $PD_n$ for accumulation of the charges photogenerated by said photodiodes, $ST_1$ - $ST_n$ are transistors for transfer switching scanned by the shift register SR as the driving means for driving these for outputting the signal charges accumulated in the capacitors $C_1$ - $C_n$ to output terminals SOUT. $TR_1$ - $TR_n$ are transistors for reset switch provided for cancelling the residual charges after signal read.

The sensor cell of the combination constitution of the photodiode, the capacitor, the transistor for transfer and the transistor for reset is provided in an array, for example, arranged in number of 1960.

These sensor cells form capacitances $C_{A1}$ - $C_{An}$ through the electroconductive layer 302 and the insulating layer.

And, the electroconductive layer 302 forms a floating capacitance $C_B$.

Next, the read method is to be described.

When each photodiode is irradiated with light, a signal voltage corresponding to the accumulated voltage is read as the signal in the read means RM including the output terminals MOUT and AP connected to the electroconductive layer.

When the voltage of the signal outputted from MOUT becomes the voltage corresponding to a desired accumulation time, driving of the shift register is controlled by the arithmetic operation circuit CC, whereby the transistors $ST_1$ is successively turned on to output the output signal photoelectrically converted at SOUT. At this time, the respective reset transistors $TR_1$ - $TR_n$ are successively turned on after respective readings are performed, whereby residual voltage is cancelled by the bias voltage br.

Having described in the above with reference to Fig. 13, it is basically the same as shown in the first example. A bias voltage source for giving reverse bias to the phototransistor is denoted by bd.

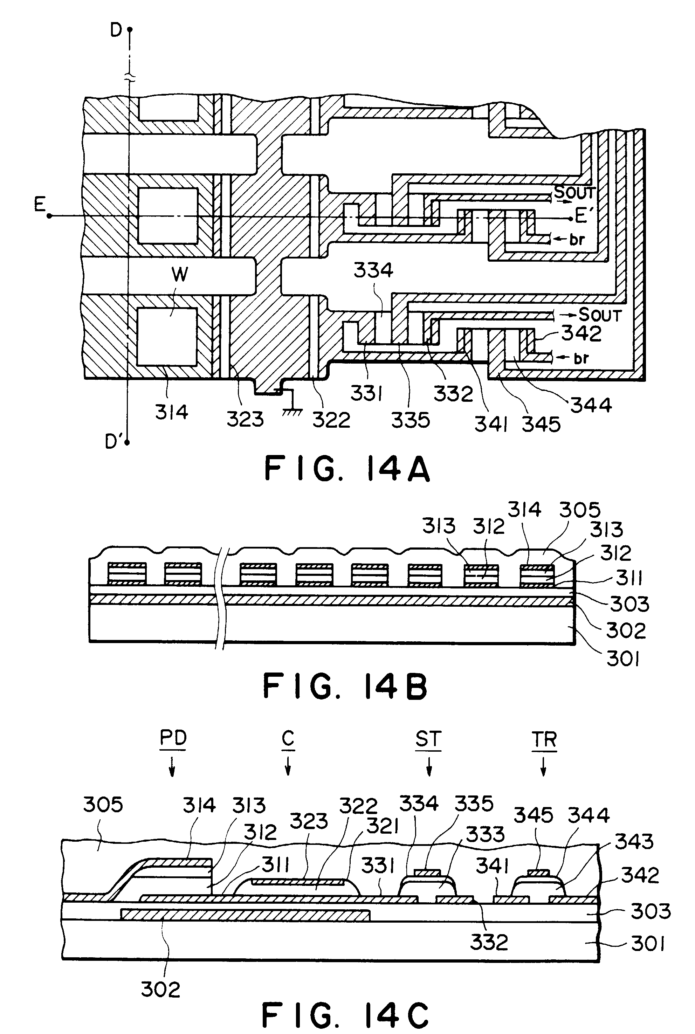

Fig. 14A is a schematic top view showing the principal part of the lengthy sensor device according to this Example.

Fig. 14B is a schematic sectional view taken along the line D-D' in Fig. 14A.

Fig. 14C is a schematic sectional view taken along the line E-E' in Fig. 14A.

According to this Example, the light-receiving section PD is constituted of a lower layer electrode 311 of Al, a p-type semiconductor layer 312, a n-type semiconductor layer 313, an upper electrode 314 of Al. The information light enters the photoelectric converting regions, namely 312, 313, through the opening formed at the upper electrode 314. Here, either 312 or 313 may be upside or downside.

The charge accumulating section C comprises a lower layer electrode 321, an insulating layer 322 comprising silicon oxide and an upper electrode 323. The transistor ST for transfer has a TFT structure of n channels formed of a drain electrode 331, a source electrode 332, a channel region 333 comprising a polycrystalline silicon, an insulating layer 334 comprising silicon nitride and a gate electrode 335. Similarly, the transistor for reset TR is constituted of a drain electrode 341, a source electrode 342, a channel region 343 comprising a polycrystalline silicon, an insulating layer 344 of silicon nitride and a gate electrode 345.

These units comprising the light-receiving section, the accumulating section, the transfer section and the reset section are arranged on the same substrate in a large number with the shorter length of A4 size, and a PSG film is formed as the protective layer 305 thereon.

The common electroconductive layer 302 for reading the average voltage which becomes the parameter for determining the charge accumulation time during read is formed only below the light-receiving section.

Here, the p-type semiconductor 312 comprises a polycrystalline silicon carbide (SiC) doped with boron, and the n-type semiconductor layer 313 comprises a polycrystalline silicon cabide (SiC) doped with phosphorus.

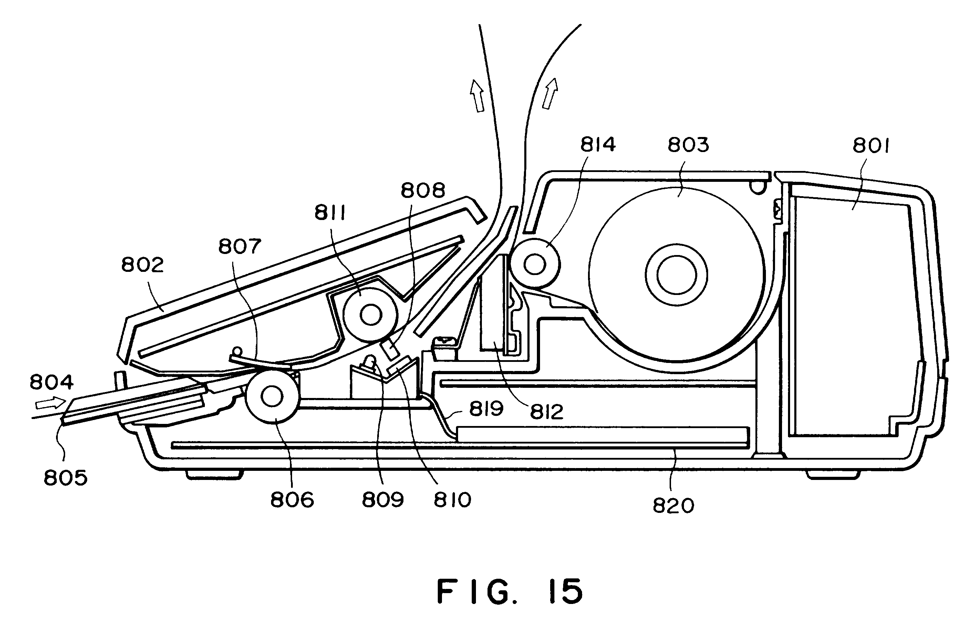

Fig. 15 shows an example of the signal processing device according to the present invention, and is specifically a schematic sectional view showing a facsimile as an example of the signal processing device having the photosensor device shown in Figs. 13 and 14 mounted thereon.

801 is a power source for driving of facsimile 802 an operation panel and 803 a recording paper for recording received images.

An original 804 is inserted through an original inserting opening 805 to a feeding roller 806 with the image information surface being face down. At this time, on detection of the original by an original detection sensor not shown, the feeding roller 806 begins to be rotated in the clockwise direction. The feeding roller 806 and the separating blade 807 are pressure contacted, and when plural sheets of original come, they are sent downstream as separated one by one.

The photosensor device 810 is arranged so as to read the image through the equal size type lens array 808 by irradiation of the original from a light source 809.

And, when the tip end of the original is sandwiched between the both of the lens array 808 and the platen roller 811, the image information is read while delivering the original by the platen roller 811. 812 is a thermal head for reproducing the received image onto a heat-sensitive recording paper 803, and 814 is a platen roller for recording.

820 is a system control substrate, which is connected through a wiring 819 to the photosensor device 810, and includes a circuit for driving the shift register by performing arithmetic operation of the output value read through the electroconductive layer 302 as shown in Fig. 13 to determine the accumulation time.

Of course, such circuit may be one provided on an integrated photosensor device unit including the light source and the lens array 808.

As described above, according to the present invention, the idle time required in the prior art can be obviated to enable high speed reading.

## Claims

1. A semiconductor device, comprising

   a plurality of charge accumulation type sensor elements (1005) each of said sensor elements (1005) having a semiconductor active region (1004); and
   a plurality of respective charge transferring elements ($ST_1$-$ST_n$) for transferring charge signals stored in said sensor elements, each of said charge transferring elements ($ST_1$-$ST_n$) corresponding to a respective one of said sensor elements (1005); characterised by
   a common conductive member (1002) provided with an insulating member (1003) for capacitively coupling said common conductive member (1002) to the output of each of said sensor elements through the insulating member (1003) thereby to develop a voltage signal on said common conductive member corresponding to

7

the average of the output voltages of the plurality of charge accumulation sensor elements (1005); and operating means (cc) for detecting the voltage signal on said common conductive member (1002) and for producing a drive signal controlling said charge transferring elements ($ST_1$-$ST_n$) in response to the voltage on said common conductive member (1002).

2. A semiconductor device according to claim 1, wherein said charge accumulation type sensor element comprises a photoelectric converting section ($PD_1$-$PD_n$) which is connected to the charge transferring elements ($ST_1$-$ST_n$).

3. A semiconductor device according to claim 1, wherein said charge accumulation type sensor element comprises a photoelectric converting section ($PD_1$-$PD_n$) which is connected to the charge transferring elements ($ST_1$-$ST_n$) for transferring the signal charges photoelectrically converted and a switch element ($TR_1$-$TR_n$) for resetting the potential at said photoelectric converting section ($PD_1$-$PD_n$).

4. A semiconductor device according to claim 1, wherein said charge accumulation type sensor element (1005) comprises a photovoltaic element section (113).

5. A semiconductor device according to claim 4, wherein said photovoltaic section is a diode (113).

6. A semiconductor device according to claim 1, wherein said charge accumulation type sensor element (1005) comprises a photoconductive element section ($PD_1$-$PD_n$) and a charge accumulation section ($C_1$-$C_n$).

7. A semiconductor device according to any preceding claim, wherein said insulating member (1003) comprises a material selected from silicon oxide, silicon nitride or silicon oxide nitride.

8. A semiconductor device according to any of claims 1 to 6, wherein said insulating member (1003) comprises a material selected from PSG or BSG.

9. A semiconductor device according to any preceding claim, wherein said common conductive member (1002) comprises a material selected from Al, Cr, Ni, Cu, Au, Ag, Pt or W.

10. A semiconductor device according to any one of claims 1 to 8, wherein said common conductive member (1002) comprises a material selected from $SnO_2$ or ITO.

11. A semiconductor device according to any preceding claim, wherein said charge accumulation type sensor device (1005) has an active region comprising a semiconductor material (1004) having Si, Ge, Se as the main constituent.

12. A semiconductor device according to any one of claims 1 to 10, wherein said charge accumulation type sensor device (1005) has an active region comprising a semiconductor material (1004) having SiC, SiGe as the main constituent.

13. A semiconductor device according to any of claims 1 to 10, wherein said charge accumulation type sensor device (1005) has an active region comprising a semiconductor material (1004) having GaAs as the main constituent.

14. A semiconductor device according to any of claims 1 to 10, wherein said charge accumulation type sensor device (1005) has an active region (1004) comprising a non-crystalline semiconductor material having Si, Ge, Se as the main constituent.

15. A semiconductor device according to any one claims 1 to 10, wherein said charge accumulation type sensor device (1005) has an active region (1004) comprising a non-single crystalline semiconductor material having SiC, SiGe as the main constituent.

16. A semiconductor device according to any of claims 1 to 10, wherein said charge accumulation type sensor element (1005) has an active region (1004) comprising an super-lattice structure.

17. A semiconductor device according to any preceding claim, wherein said device is a line sensor device.

18. A semiconductor device according to any of claims 1 to 16, wherein said semiconductor device is an area sensor device.

**19.** A signal processing apparatus, comprising

a semiconductor device according to claim 1 and signal readout means comprising:
driving means (SR) for driving said charge transferring elements (ST$_1$-ST$_n$) in accordance with the voltage signal on said common conductive member (1002).

**20.** A scanner device for reading an image, including apparatus according to claim 19.

**21.** A facsimile device, including apparatus according to claim 19.

**22.** A camera, including apparatus according to claim 19.

**23.** A device according to any of claims 1 to 18, wherein said electroconductive members (1002) are incorporated as a common layer.

**24.** Device according to claim 23, wherein said insulating members (1003) are incorporated as a common layer.

**25.** Apparatus according to any of claims 19 to 22, wherein said electroconductive members (1002) are incorporated as a common layer.

**26.** Apparatus according to claim 25, wherein said insulating members (1003) are incorporated as a common layer.

**Patentansprüche**

**1.** Halbleiteranordnung mit

einer Vielzahl von Sensorelementen (1005) des Ladungsanreicherungstyps, wobei jedes der Sensorelemente (1005) eine aktive Halbleiterzone (1004) hat; und mit
einer Vielzahl von jeweiligen Ladungsübertragungselementen (ST$_1$ - St$_n$) zur Übertragung von in den Sensorelementen gespeicherten Ladungssignalen, wobei jedes der Ladungsübertragungselemente (ST$_1$ - St$_n$) einem jeweiligen der Sensorelemente (1005) zugehörig ist; **gekennzeichnet durch**
ein gemeinsames Leitglied (1002) mit einem Isolierglied (1003) zur kapazitiven Kopplung des gemeinsamen Leitgliedes (1002) mit dem Ausgang eines Sensorelementes durch das Isolierglied (1003), um dadurch auf dem gemeinsamen Leitglied ein Spannungssignal entsprechend dem Durchschnitt der Ausgangsspannungen der Vielzahl von Ladungsanreicherungs-Sensorelementen (1005) aufzubauen; und mit
Rechenmitteln (CC) zur Feststellung des Spannungssignals auf dem gemeinsamen Leitglied (1002) und zur Erzeugung eines Ansteuersignals, das die Ladungsübertragungselemente (ST$_1$ - St$_n$) abhängig von der Spannung auf dem gemeinsamen Leitglied (1002) steuert.

**2.** Halbleiteranordnung nach Anspruch 1, dessen Sensorelement des Ladungsanreicherungstyps über einen lichtelektrischen Wandlerabschnitt (Pd$_1$- Pd$_n$) verfügt, der mit den Ladungsübertragungselementen (ST$_1$ - St$_n$) verbunden ist.

**3.** Halbleiteranordnung nach Anspruch 1, deren Sensorelement des Ladungsanreicherungstyps über einen lichtelektrischen Wandlerabschnitt, der mit den Ladungsübertragungselementen zur Übertragung der lichtelektrisch gewandelten Signal ladungen verbunden ist, und über ein Schaltelement (TR$_1$- TR$_n$) verfügt, das das Potential am lichtelektrischen Wandlerabschnitt (PD$_1$- PD$_n$) zuücksetzt.

**4.** Halbleiteranordnung nach Anspruch 1, deren Sensorelement (1005) des Ladungsanreicherungstyps über einen photovoltaischen Elementabschnitt (113) verfügt.

**5.** Halbleiteranordnung nach Anspruch 4, deren photovoltaischer Abschnitt aus einer Diode (113) besteht.

**6.** Halbleiteranordnung nach Anspruch 1, deren Sensorelement (1005) des Ladungsanreicherungstyps über einen photoleitfähigen Elementabschnitt (PD$_1$ - PD$_n$) und über einen Ladungsanreicherungsabschnitt (C$_1$ - C$_n$) verfügt.

**7.** Halbleiteranordnung nach einem der vorstehenden Ansprüche, deren Isolierglied (1003) aus dem Material Silizi-

EP 0 365 312 B1

umoxid, Siliziumnitrid oder Siliziumoxid-Nitrid besteht.

8. Halbleiteranordnung nach einem der Ansprüche 1 bis 6, deren Isolierglied (1003) aus dem Material PSG oder BSG besteht.

9. Halbleiteranordnung nach einem der Ansprüche, deren gemeinsames Leitglied (1002) aus dem Material Al, Cr, Ni, Cu, Au, Ag, Pt oder W besteht.

10. Halbleiteranordnung nach einem der Ansprüche 1 bis 8, deren gemeinsames Leitglied (1002) aus $SnO_2$ oder ITO besteht.

11. Halbleiteranordnung nach einem der vorstehenden Ansprüche, deren Sensoreinrichtung (1005) des Ladungsanreicherungstyps über eine aktive Zone verfügt, die ein Halbleitermaterial enthält (1004), dessen Hauptbestandteil Si, Ge, Se ist.

12. Halbleiteranordnung nach einem der Ansprüche 1 bis 10, deren Sensoreinrichtung (1005) des Ladungsanreicherungstyps über eine aktive Zone verfügt, die ein Halbleitermaterial (1004) enthält, das hauptsächlich aus SiGe besteht.

13. Halbleiteranordnung nach einem der Ansprüche 1 bis 10, deren Sensoreinrichtung (1005) des Ladungsanreicherungstyps über eine aktive Zone verfügt, die ein Halbleitermaterial (1004) mit Ga, As als Hauptbestandteil enthält.

14. Halbleiteranordnung nach einem der Ansprüche 1 bis 10, deren Sensoreinrichtung (1005) des Ladungsanreicherungstyps über eine aktive Zone (1004) verfügt, die die aus einem nichtkristallinen Halbleitermaterial mit Si, Ge, Se als Hauptbestandteil ist.

15. Halbleitranordnung nach einem der Ansprüche 1 bis 10, deren Sensoreinrichtung (1005) über eine aktive Zone (1004) verfügt, die aus einem Nichteinkristall-Halbleitrmaterial mit SiC, SiGe als Hauptbestandteil ist.

16. Halbleiteranordnung nach einem der Ansprüche 1 bis 10, deren Sensorelement (1005) eine aktive Zone (1004) mit einer Überstruktur enthält.

17. Halbleiteranordnung nach einem der vorstehenden Ansprüche, deren Anordnung eine Zeilensensoranordnung ist.

18. Halbleiteranordnung nach einem der Ansprüche 1 bis 16, deren Halbleiteranordnung eine Flächensensoranordnung ist.

19. Signalverarbeitungsgerät mit:

   einer Halbleiteranordnung nach Anspruch 1 und Signalauslesemitteln, bestehend aus:
   Ansteuermitteln (SR) zur Ansteuerung der Ladungsübertragungselemente ($ST_1$ - $St_n$) abhängig vom Spannungssignal auf dem gemeinsamen Leitglied (1002).

20. Abtasteinrichtung zum Lesen eines Bildes mit einem Gerät nach Anspruch 19.

21. Faksimileeinrichtung, mit einem Gerät nach Anspruch 19.

22. Kamera, mit einem Gerät nach Anspruch 19.

23. Anordnung nach einem der Ansprüche 1 bis 18, deren elektrische Leitglieder (1002) als gemeinsame Schicht eingearbeitet sind.

24. Anordnung nach Anspruch 23, deren Isolierglieder (1003) als gemeinsame Schicht eingearbeitet sind.

25. Gerät nach einem der Ansprüche 19 bis 22, deren elektrische Leitglieder (1002) als gemeinsame Schicht eingearbeitet sind.

26. Gerät nach Anspruch 25, deren Isolierglieder (1003) als gemeinsame Schicht eingearbeitet sind.

10

## Revendications

1. Dispositif à semiconducteur, comprenant

   un ensemble d'éléments (1005) détecteurs du type à accumulation de charge, chacun desdits éléments (1005) détecteurs ayant une région (1004) active à semiconducteur; et
   un ensemble d'éléments ($ST_1$-$ST_n$) de transfert de charge respectifs pour transférer des signaux de charge stockés dans lesdits éléments détecteurs, chacun desdits éléments ($ST_1$-$ST_n$) de transfert de charge correspondant à l'un respectif desdits éléments (1005) détecteurs;

   caractérisé par

   un élément (1002) conducteur commun muni d'un élément (1003) isolant pour coupler de façon capacitive ledit élément (1002) conducteur commun à la sortie de chacun desdits éléments détecteurs par l'intermédiaire de l'élément (1003) isolant afin de produire un signal de tension sur ledit élément conducteur commun qui correspond à la moyenne des tensions de sortie de l'ensemble d'éléments (1005) détecteurs à accumulation de charge; et
   des moyens (cc) de commande destinés à détecter le signal de tension sur ledit élément (1002) conducteur commun, pour produire un signal d'attaque commandant lesdits éléments ($ST_1$-$ST_n$) de transfert de charge en réponse à la tension sur ledit élément (1002) conducteur commun.

2. Dispositif à semiconducteur selon la revendication 1, dans lequel ledit élément détecteur du type à accumulation de charge comprend une section ($PD_1$-$PD_n$) de conversion photoélectrique qui est connectée aux éléments ($ST_1$-$ST_n$) de transfert de charge.

3. Dispositif à semiconducteur selon la revendication 1, dans lequel ledit élément détecteur du type à accumulation de charge comprend une section ($PD_1$-$PD_n$) de conversion photoélectrique qui est connectée aux éléments ($ST_1$-$ST_n$) de transfert de charge pour transférer les charges de signaux converties photoélectriquement et un élément ($TR_1$-$TR_n$) commutateur pour réinitialiser le potentiel dans ladite section ($PD_1$-$PD_n$) de conversion photoélectrique.

4. Dispositif à semiconducteur selon la revendication 1, dans lequel ledit élément (1005) détecteur du type à accumulation de charge comprend une section (113) à élément photovoltaïque.

5. Dispositif à semiconducteur selon la revendication 4, dans lequel ladite section photovoltaïque est une diode (113).

6. Dispositif à semiconducteur selon la revendication 1, dans lequel ledit élément (1005) détecteur du type à accumulation de charge comprend une section ($PD_1$-$PD_n$) à élément photoconducteur et une section ($C_1$-$C_n$) d'accumulation de charge.

7. Dispositif à semiconducteur selon l'une quelconque des revendications précédentes, dans lequel ledit élément (1003) isolant comprend un matériau sélectionné parmi l'oxyde de silicium, le nitrure de silicium ou l'oxyde-nitrure de silicium.

8. Dispositif à semiconducteur selon l'une quelconque des revendications 1 à 6, dans lequel ledit élément (1003) isolant comprend un matériau sélectionné parmi un verre PSG ou BSG.

9. Dispositif à semiconducteur selon l'une quelconque des revendications précédentes, dans lequel ledit élément (1002) conducteur commun comprend un matériau sélectionné parmi Al, Cr, Ni, Cu, Au, Ag, Pt, ou W.

10. Dispositif à semiconducteur selon l'une quelconque des revendications 1 à 8, dans lequel ledit élément (1002) conducteur commun comprend un matériau sélectionné parmi $SnO_2$ ou ITO.

11. Dispositif à semiconducteur selon l'une quelconque des revendications précédentes, dans lequel ledit dispositif (1005) détecteur du type à accumulation de charge a une région active comprenant un matériau (1005) semiconducteur contenant du Si, du Ge, du Se, en tant que constituant principal.

12. Dispositif à semiconducteur selon l'une quelconque des revendications 1 à 10, dans lequel ledit dispositif (1005) détecteur du type à accumulation de charge a une région active comprenant un matériau (1005) semiconducteur contenant du SiC, du SiGe en tant que constituant principal.

13. Dispositif à semiconducteur selon l'une quelconque des revendications 1 à 10, dans lequel ledit dispositif (1005) détecteur du type à accumulation de charge a une région active comprenant un matériau (1004) semiconducteur contenant du GaAs en tant que constituant principal.

14. Dispositif à semiconducteur selon l'une quelconque des revendications 1 à 10, dans lequel ledit dispositif (1005) détecteur du type à accumulation de charge a une région active (1004) comprenant un matériau semiconducteur non cristallin contenant du Si, du Ge, du Se en tant que constituant principal.

15. Dispositif à semiconducteur selon l'une quelconque des revendications 1 à 10, dans lequel ledit dispositif (1005) détecteur du type à accumulation de charge a une région active (1004) comprenant un matériau semiconducteur non monocristallin contenant du SiC, du SiGe en tant que constituant principal.

16. Dispositif à semiconducteur selon l'une quelconque des revendications 1 à 10, dans lequel ledit élément (1005) détecteur du type à accumulation de charge a une région active (1004) comprenant une structure de super-réseau.

17. Dispositif à semiconducteur selon l'une quelconque des revendications précédentes, dans lequel ledit dispositif est un dispositif détecteur linéaire.

18. Dispositif à semiconducteur selon l'une quelconque des revendications 1 à 16, dans lequel ledit dispositif semiconducteur est un dispositif détecteur bidimensionnel.

19. Appareil de traitement de signal, comprenant:

un dispositif à semiconducteur selon la revendication 1, et des moyens de lecture de signaux comprenant: des moyens (SR) d'attaque pour attaquer lesdits éléments ($ST_1$-$ST_n$) de transfert de charge en fonction du signal de tension sur ledit élément (1002) conducteur commun.

20. Dispositif de lecture à balayage pour lire une image, comportant un appareil selon la revendication 19.

21. Dispositif de télécopie, comportant un appareil selon la revendication 19.

22. Appareil photographique, comportant un appareil selon la revendication 19.

23. Dispositif selon l'une quelconque des revendications 1 à 18, dans lequel lesdits éléments (1002) électroconducteurs sont intégrés sous la forme d'une couche commune.

24. Dispositif selon la revendication 23, dans lequel lesdits éléments (1003) isolants sont intégrés sous la forme d'une couche commune.

25. Appareil selon l'une quelconque des revendications 19 à 22, dans lequel lesdits éléments (1002) électroconducteurs sont intégrés sous la forme d'une couche commune.

26. Appareil selon la revendication 25, dans lequel lesdits éléments (1003) isolants sont intégrés sous la forme d'une couche commune.

C

ARITHMETIC
OPERATION
CIRCUIT

SR

SHIFT REGISTER

AM

OUT

SW1    SW2         SWn-1    SWn

S1    S2         Sn-1    Sn

# FIG. 1

| STORE | READ | AO | STORE | READ | AO |
|-------|------|-----|-------|------|-----|
| tn-1 | tr | tc | tn | tr | tc |

|← IDLE READ →|← 1ST READ →|

TIME

# FIG. 2

# FIG. 3

FIG. 4A

PR            PR

n | P | n | P | n     104
                      103
                      102
                      101

104a 104d 104b 104e 104c

FIG. 4B

107              106

n | P | n | P | n
104d
                 102

FIG. 4C

108              109

n | P | n | P | n
104d              104e
                 102

FIG. 4D

111a  111d  111e  110  111b

110

108
104d
112                      104e
                         111c

FIG. 5

FIG. 6

FIG. 7

FIG. 8

FIG. 9

FIG. 10

FIG. 11

FIG. 12

EP 0 365 312 B1

F I G. 13

**F I G. 14 A**

**F I G. 14 B**

**F I G. 14 C**

FIG. 15

EP 0 365 312 B1